# EUROPÄISCHE PATENTSCHRIFT

(11) **EP 0 997 001 B1**
(45) Veröffentlichungstag und Bekanntmachung des Hinweises auf die Patenterteilung: **06.11.2002**
(21) Anmeldenummer: 98934760.4
(22) Anmeldetag: 20.05.1998
(51) Int. Cl.: H03K 17/0814

(54) **SCHALTUNGSANORDNUNG, INSBESONDERE ZUM ANSTEUERN EINER ZÜNDENDSTUFE**
CIRCUIT ARRANGEMENT, IN PARTICULAR FOR TRIGGERING AN IGNITION END STAGE
AGENCEMENT DE CIRCUITS, NOTAMMENT POUR DECLENCHER UN ETAGE FINAL D'AMOR AGE

(30) Priorität: 08.07.1997 DE 19729106; 16.04.1998 DE 19816791
(43) Veröffentlichungstag der Anmeldung: 03.05.2000
(73) Patentinhaber: ROBERT BOSCH GMBH, 70442 Stuttgart (DE)
(72) Erfinder: MICHEL, Hartmut, D-72762 Reutlingen (DE)
(86) Internationale Anmeldenummer: DE9801391
(87) Internationale Veröffentlichungsnummer: WO99003205

(56) Entgegenhaltungen:
- EP-A- 0 715 409
- DE-A- 2 238 983
- DE-A- 3 145 554
- US-A- 4 665 459
- PATENT ABSTRACTS OF JAPAN vol. 008, no. 088 (E-240), 21.April 1984 -& JP 59 006622 A (FUJI DENKI SEIZO KK), 13.Januar 1984,

## Beschreibung

Die Erfindung betrifft eine Schaltungsanordnung, insbesondere zum Ansteuern einer Zündendstufe, mit einem Leistungsschalttransistor und mindestens einem schaltbaren Freilaufkreis und/oder schaltbaren autonomen Hilfskanal.

### Stand der Technik und Aufgabe

Aus der EP-A 0 715 409 ist eine Schaltungsanordnung mit den Merkmalen gemäß dem Oberbegriff des unabhängigen Anspruchs 1 bekannt. Die Aufgabe der vorliegenden Erfindung ist es, den als Freilaufkreis arbeitenden Hilfspfad so zu realisieren, daß er bei der Herstellung des Leistungsschalttransistors ohne zusätzliche Prozeßschritte erhalten werden kann.

Es ist bekannt, daß beim Abschalten induktiver Lasten aufgrund von in der induktiven Last gespeicherter Energie Spannungsspitzen auftreten können. Ist ein möglichst verlustarmer Schalter gewünscht, wie zum Beispiel bei einer getakteten Stromregelung im Lastkreis, so ist bekannt, daß ein Freilaufkreis mit möglichst niedrigem Innenwiderstand, auf den der Laststrom beim Abschalten des Leistungsschalters umkommutiert wird, eine geeignete Lösung darstellt.

Ist dagegen ein schneller Abbau der induktiven Energie zum Beispiel beim Schalten eines Magnetventils oder das Erzielen einer hohen Primärspannung beim Betrieb eines Zünd-Transformators gewünscht, so muß ein gegebenenfalls vorhandener Freilaufkreis schaltbar ausgeführt werden.

Aus der DE 4344126 A1 ist beispielsweise eine Schaltungsanordnung mit einem schaltbaren Freilaufkreis bekannt, wobei dieser eine Freilaufdiode, einen Freilauf-Schalttransistor und ein Halbleiterbauelement mit definierter Durchbruchspannung aufweist. Diese Schaltungsanordnung ist relativ kompliziert und nur aufwendig herstellbar.

### Vorteile der Erfindung

Die erfindungsgemäße Schaltungsanordnung mit den im Anspruch 1 genannten Merkmalen bietet demgegenüber den Vorteil, daß diese einfach aufgebaut ist und ohne zusätzliche Prozeßschritte bei der Herstellung des Leistungsschalttransistors erhalten werden kann. Dadurch, daß der Freilaufkreis bzw. ein autonomer Hilfskanal von einem ansteuerbaren Vierschichtelement gebildet wird, kann mittels weniger, mit einer Prozessierung des Leistungsschalttransistors verknüpfbarer Prozeßschritte die gesamte Schaltungsanordnung geschaffen werden. Die Erfindung besteht insbesondere in der Bereitstellung vertikaler Leistungstransistoren mit autonomen Hilfskanälen, deren Spannungsfestigkeit mit der des zugehörigen Leistungstransistors vergleichbar ist und die einfach (ohne zusätzliche Prozeßschritte) realisiert werden können. In bevorzugter Ausgestaltung der Erfindung ist vorgesehen, daß ein Thyristor in den Leistungsschalttransistor monolithisch integriert ist und vorzugsweise als laterales Bauelement in den Randbereich eines Leistungsschalttransistor-Kristalls integriert ist. Hierdurch entsteht nur ein geringer zusätzlicher Platzbedarf für die Aufnahme des Thyristors, wobei durch die laterale Anordnung des Thyristors in dem Kristall gleichzeitig eine hohe Temperaturstabilität einstellbar ist.

Weitere vorteilhafte Ausgestaltungen der Erfindung ergeben sich aus den übrigen, in den abhängigen Ansprüchen genannten Merkmalen.

### Zeichnungen

Die Erfindung wird nachfolgend in einem Ausführungsbeispiel anhand der zugehörigen Zeichnungen näher erläutert. Es zeigen:
- Figur 1: eine Schaltungsanordnung eines Leistungsschalttransistors mit schaltbarem Freilaufkreis;
- Figur 2: schematisch eine Schnittdarstellung durch einen Teilbereich eines die Schaltungsanordnung gemäß Figur 1 aufweisenden Halbleiter-Kristalls und
- Figur 3: eine Draufsicht auf das Halbleiter- Kristall gemäß Figur 2, unter Weglassung von Metallisierungen;
- Figur 4: eine Schaltungsanordnung mit einem schaltbaren autonomen Hilfskanal,
- Figur 5: schematisch eine Schnittdarstellung analog Figur 2 für eine Schaltung nach Figur 4.

### Beschreibung der Ausführungsbeispiele

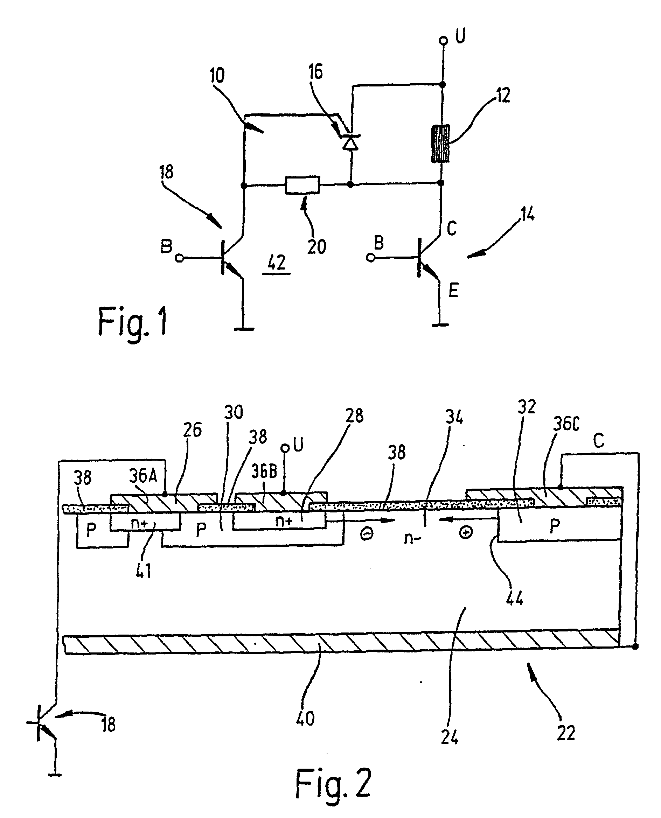

In Figur 1 ist eine Schaltungsanordnung 10 einer im Detail nicht dargestellten Zündendstufe dargestellt. Mittels der Schaltungsanordnung 10 wird eine Primärwicklung 12 einer Zündspule mit einer Spannungsversorgung U, beispielsweise einer Batterie eines Kraftfahrzeuges, verbunden. Hierzu ist ein Leistungsschalttransistor 14 vorgesehen, dessen Kollektor mit dem einen Anschluß der Primärwicklung 12 verbunden ist. Der Emitter des Leistungsschalttransistors 14 ist mit Masse verbunden, während die Basis mit einem Ansteuersignal beaufschlagbar ist.

Ferner ist ein Thyristor 16 vorgesehen, dessen Anode mit dem Kollektor des Leistungsschalttransistors 14 und dessen Kathode mit der Versorgungsspannung U verbunden ist. Die Steuerelektrode des Thyristors 16 ist mit dem Kollektor eines Schalttransistors 18 verbunden, dessen Emitter an Masse liegt und dessen Basis über eine nicht dargestellte Ansteuerschaltung ansteuerbar ist. Zwischen der Anode des Thyristors 16 und dem Kollektor des Schalttransistors 18 ist ferner ein Widerstand 20 geschaltet.

In Figur 2 ist der planare Aufbau des Thyristors 16 in einer schematischen Schnittdarstellung durch ein planares monolithisch integriertes Bauelement 22 gezeigt. Das Bauelement 22 weist ferner den Leistungsschalttransistor 14 auf, der jedoch hier nicht näher dargestellt ist. Das Bauelement 22 besitzt ein Kristall 24 aus einem n⁻-dotierten Material, das gleichzeitig den Kollektor des Leistungsschalttransistors 14 bildet. In diesem n⁻-dotierten Bereich 24 sind die einzelnen Zonen des Thyristors 16, der quasi von einer Reihenschaltung von drei Dioden mit dem Steueranschluß 26 gebildet wird, in an sich bekannter Weise für die Erzeugung von Zonen bestimmter Dotierung in Halbleiter-Kristallen eingebracht. Der Thyristor 16 weist eine mit der Spannungsversorgung U verbundene n⁺-dotierte Zone 28, eine die Zone 28 umgreifende p-dotierte Zone 30, eine mit dem Kollektor C verbundene p-dotierte Zone 32 und eine zwischen den p-dotierten Zonen 30 und 32 liegende Zone 34 des n⁻-dotierten Bereiches 24 auf. Ferner sind übliche Metallkontaktierungen 36 A, B, C zur elektrischen Kontaktierung des Thyristors 16 und Feldoxidschichten 38 zum Erreichen einer Isolierung der einzelnen Kontakte untereinander vorhanden. Das Bauelement 22 weist ferner eine Metallisierung 40 auf, die über den Kollektor des Leistungsschalttransistors 14 mit der p-dotierten Zone 32 kurzgeschlossen ist. Der Thyristor 16 bildet mit dem Schalttransistor 18 einen schaltbaren Freilaufkreis 42 (Figur 1) für die Primärwicklung 12.

Die in den Figuren 1 und 2 gezeigte Schaltungsanordnung übt folgende Funktionen aus:

Im normalen Betrieb ist der Thyristor 16 deaktiviert, so daß bei angesteuertem Leistungsschalttransistor 14 die Primärwicklung 12 mit der Versorgungsspannung U und Masse verbunden ist. Zur Erreichung dieser Deaktivierung des Thyristors 16 wird über den Schalttransistor 18 das Potential der p-dotierten Zone 30 auf Masse gelegt, so daß eine Verbindung zwischen dem n⁺-dotierten Bereich 28 und der n⁻-dotierten Zone 34 gesperrt ist.

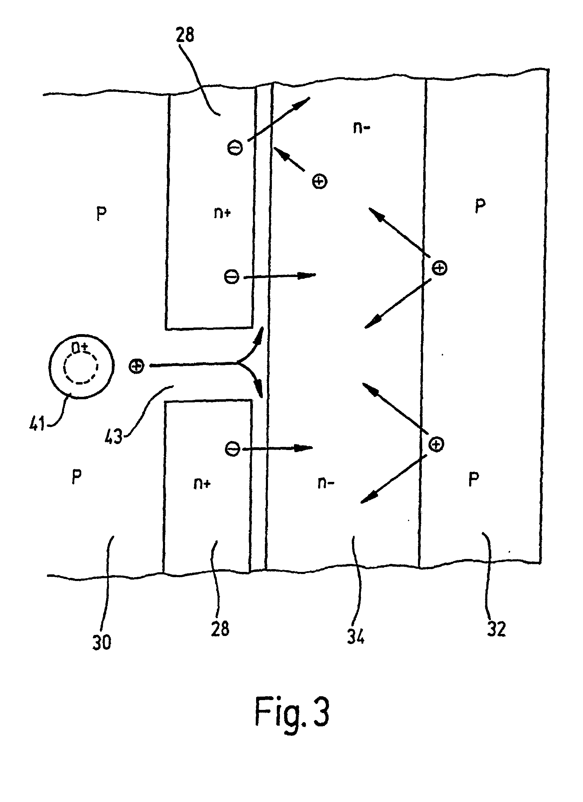

Ist der Schalttransistor 18 gesperrt, kann beim Abschalten des Leistungsschalttransistors 14 durch das hiermit verbundene Ansteigen der Kollektorspannung des Leistungsschalttransistors 14 der Thyristor 16 über den Widerstand 20 gezündet werden. Der Widerstand 20 dient als Strombegrenzungswiderstand und ist beispielsweise als externer Widerstand oder als sogenannter Brunnenwiderstand innerhalb des Bauelementes 22 ausgebildet. Der Brunnenwiderstand ist der Quotient aus Spannung zwischen Metallisierung 40 und Anschluß 26 und des Stroms durch eine n⁺-dotierte Zone 41 in der p-Zone 30 (Figur 3). Durch das Ansteigen der Kollektorspannung des Leistungsschalttransistors 14 wird über den Steueranschluß 26 die p-dotierte Zone 30 auf eine höhere Spannung gezogen, als die mit der Versorgungsspannung U verbundene n⁺-dotierte Zone 28. Durch einen hierdurch eingespeisten Zündstrom zündet der Thyristor 16. Die Einspeisung des Zündstromes wird hierbei auf einen kleinen Bereich der p-dotierten Zone 30 beschränkt, so daß ein Bahnwiderstand in der n⁻-dotierten Zone 34 von der Grenze zur Feldoxidschicht 38 bis zur Metallisierung 40 mehrere kΩ beträgt. Hieraus resultiert, daß bei der Zündung des Thyristors 16 bereits eine geringe Injektion von Elektronen in die n⁻-dotierte Zone 34 von der n⁺-dotierten Zone 28 in der Größenordnung von einigen 100 µA ausreicht, um das Potential der n⁻-dotierten Zone 34 gegenüber der p-dotierten Zone 32 um eine Flußspannung abzusenken.

Um die Zündung des Thyristors 16 noch wirksamer zu gestalten, kann vorgesehen sein, die n⁺-dotierte Zone 28 zu schlitzen (Bereich 43) und den Zündstrom direkt in den Grenzbereich zwischen der p-dotierten Zone 30 und der n⁻-dotierten Zone 34 einzuspeisen (Figur 3). Nach der Zündung werden die Ladungsträger nach allen Seiten in die p-dotierte Zone 30 und die n⁻-dotierte Zone 34 injiziert, der Stromfluß breitet sich über den gesamten als Vierschichtelement 28, 30, 34, 32 ausgebildeten Rand aus.

Parallel zu diesem Stromfluß entsteht ein weiterer durch den direkten Elektronenstrom von der n⁺-dotierten Zone 28 (mit der p-dotierten Zone 30 als Basis) nach der Metallisierung 40. Dadurch erhöht sich der stromtragende Querschnitt erheblich.

Durch Zünden des Thyristors 16 ist der Freilaufkreis 42 (Figur 1) aktiviert. Wird der Leistungsschalttransistor 14 über eine Ansteuerung wieder eingeschaltet, sinkt das Potential der p-dotierten Zone 32 und der n⁻-dotierten Zone 34, so daß der Thyristor 16 gelöscht wird.

Um bei hohen Kollektorspannungen des Leistungsschalttransistors 14 ein ungewolltes Zünden des Thyristors 16 durch Sperrschichtberührung (punch through) zwischen der p-dotierten Zone 30 und der p-dotierten Zone 32 zu vermeiden, steht der Metallkontakt 36 C des Kollektors C (in Figur 2 rechts dargestellt) über den Rand 44 über, so daß durch die daraus resultierende Schirmwirkung eine laterale Sperrschichtberührung von der p-dotierten Zone 30 nach der p-dotierten Zone 32 sicher vermieden wird.

Wird das beschriebene Prinzip angewendet, um zum Beispiel eine verlustarme getaktete Stromregelung des Spulenstroms in der Primärwicklung 12 zu realisieren, so ist zu beachten, daß die Einleitung der Zündung bei aktiviertem Freilauf durch den Thyristor 16 nach folgendem Ablauf geschehen muß:
1. Der Leistungsschalttransistor 14 wird leitend geschaltet und löscht den Thyristor 16. Der Schalttransistor 18 wird gleichzeitig leitend geschaltet.
2. Nach der Freiwerdezeit von dem Thyristor 16 wird der Leistungsschalttransistor 14 abgeschaltet und damit die Zündung auf hohem Spannungsniveau am Kollektor C eingeleitet.

Die gewählte Lateralgeometrie für den Thyristor 16 mit Anodenkurzschluß zwischen der Metallisierung 36 und der Metallisierung 40 und der Option eines Kathoden-Kurzschlusses zwischen der n⁺-dotierten Zone 28 und der p⁺-dotierten Zone 30 bietet die Möglichkeit kleiner Freiwerdezeiten und hoher Betriebstemperaturen.

Weitere Optimierungsmöglichkeiten für das Abschalten des Thyristors 16 bestehen in einer Variation des Abstandes der p-dotierten Zonen 30 beziehungsweise 32 zueinander. Hierdurch wird die Stromverstärkung des lateralen pn⁻-p-Transistors und die Größe des Anodenkurzschlusses festgelegt. Gleichzeitig wird das Sperrverhalten der pnp-Struktur innerhalb der vier aktiven npnp-Zonen des Thyristors 16 beeinflußt.

Die erfindungsgemäße Schaltungsanordnung 10 kann beispielsweise für eine getaktete Zündendstufe verwendet werden, bei der ein über das Tastverhältnis einstellbarer mittlerer Strom mit geringer Verlustleistung in der Zündendstufe für eine Energieregelung eines Zündfunkens eingesetzt wird.

Ferner kann die erfindungsgemäße Schaltungsanordnung 10 für eine verlustarme Aufrechterhaltung eines für eine Zündung ausreichenden Spulenstromes über eine längere Zeit nach Ende der Ladephase eingesetzt werden.

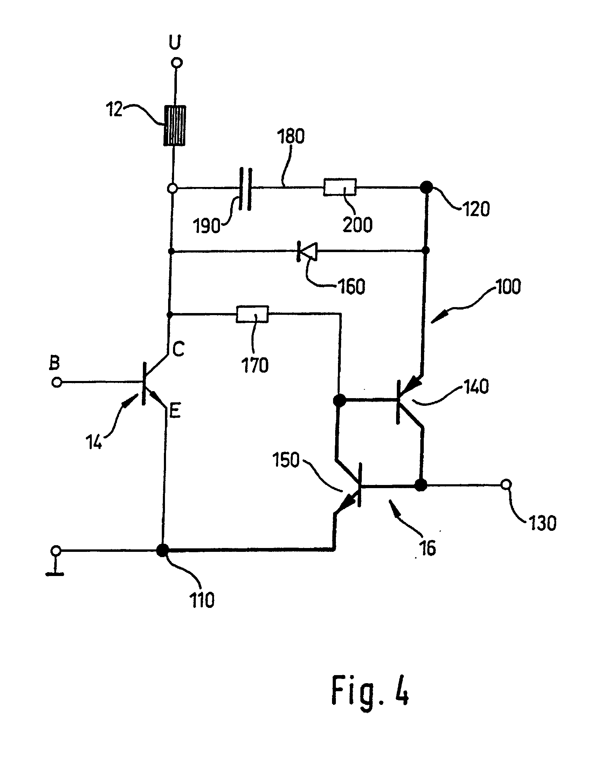

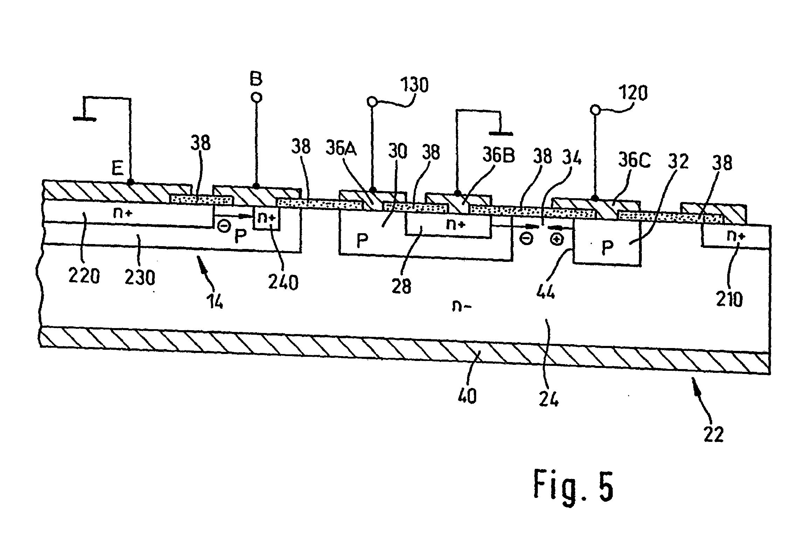

Figur 4 zeigt ein Ausführungsbeispiel der erfindungsgemäßen Schaltungsanordnung mit einem autonomen Hilfskanal 100. Der über seinen Basisanschluß B ansteuerbare Leistungsschalttransistor 14 ist kollektorseitig mit einer induktiven Last 12 verbunden, die ihrerseits mit der Spannungsversorgung U verbunden ist. Der autonome Hilfskanal 100 wird zwischen einem Hilfskanalausgang 110 und einem Hilfskanaleingang 120 durch ein Vierschichtelement 140, 150 gebildet, wobei mit Bezugszeichen 140 bzw. 150 die beiden Teiltransistoren des Vierschichtelements bezeichnet sind. Der Hilfskanalausgang 110 ist mit Masse verbunden, der Hilfskanaleingang 120 ist über einen Pfad 180, der durch die Reihenschaltung eines Kondensators 190 und eines Widerstands 200 gebildet wird, mit dem Kollektor C des Leistungsschalttransistors 14 verbunden. Eine aufbaubedingte Diode 160 (vergleiche Figur 5) ist zum Pfad 180 parallel geschaltet. Die Basis des ersten Teiltransistors 140 ist über einen aufbaubedingten Widerstand 170 (vergleiche Figur 5) mit dem Kollektor des Leistungsschalttransistors 14 verbunden. Die Basis des zweiten Teiltransistors 150 ist über einen Steuereingang 130 ansteuerbar.

Der Leistungsschalttransistor 14 in Figur 4 stellt analog zum Leistungsschalttransistor in Figur 1 einen vertikalen Haupttransistor dar, der kollektorseitig mit einer induktiven Last, z.B. einer Zündspule, verbunden ist. Im gewählten Schaltungsbeispiel ist ein mit dicken Linien markierter autonomer Hilfskanal 100 vorgesehen, der einen über den Steuereingang 130 ansteuerbaren, von der Kollektoremitterstrecke des Leistungsschalttransistors 14 unabhängigen Strompfad darstellt. Im gewählten Schaltungsbeispiel dient die Zündspule 12 als Primärspule einer Transformatorwicklung zur magnetischen Induktion eines Zündfunkens in der Sekundärspule. Soll die induktive Last 12 nach einer gewissen Zeit unabhängig vom Leistungsschalttransistor 14 wechselspannungsmäßig mit Masse verbunden werden, so kann dies über den wechselspannungsmäßig mit dem Kollektor des Leistungsschalttransistors 14 verbundenen autonomen Hilfskanal 100 erfolgen, sofern er entsprechend über den Steuereingang 130 angesteuert wird. Dies hat den Vorteil, daß unabhängig von der Basisansteuerung des Leistungsschalttransistor 14 eine schnelle Zurverfügungstellung eines Hilfskanals zur wechselspannungsmäßigen Erdung der induktiven Last gewährleistet wird. Das Vierschichtelement 16 ist nur kapazitiv mit der Zündspule verbunden; der Hilfskanaleingang 120 ist im gezeigten Ausführungsbeispiel über den Pfad 180 mit dem Kollektor des Leistungsschalttransistors 14 verbunden. Für andere Anwendungen sind jedoch auch andere Beschaltungen des Hilfskanaleingangs 120 vorsehbar. Die einzige funktionale Einschränkung hinsichtlich der von der Kollektoremitterstrecke des Leistungsschalttransistors 14 unabhängigen Schaltbarkeit des Hilfskanals 100 stellt die aufbaubedingte Diode 160 dar (vergleiche Figur 5); der Hilfskanaleingang 120 darf mit keiner höheren Spannung betrieben werden als der Spannung am Kollektor C des Leistungsschalttransistors 14. Im Gegensatz zur Schaltungsanordnung nach Figur 1, bei der der Stromfluß vom Kollektor des Leistungsschalttransistors 14 über den Thyristor 16 zur Spannungsversorgung U erfolgt, fließt in der Schaltungsanordnung nach Figur 4 bei angesteuertem Hilfskanal der Strom durch den Hilfskanal in umgekehrter Richtung vom Kollektor des Leistungsschalttransistors 14 über das Vierschichtelement 16 nach Masse, also parallel zum Stromfluß durch den Leistungsschalttransistor 14. Eine weitere mögliche Anwendung des autonomen Hilfskanals stellt ein verzögertes Einschalten des Zündfunkens dar, der durch eine entsprechende Ansteuerung des Steuereingangs 130 erzielt werden kann. Es sind auch mehrere parallel geschaltete, jedoch unabhängig voneinander ansteuerbare Hilfskanäle 100 denkbar, auch in Kombination mit einem Freilaufkreis nach Figur 1.

Figur 5 zeigt eine Schnittdarstellung durch einen Halbleiterkristall für eine Schaltungsanordnung nach Figur 4; der Aufbau der Schichtanordnung sowie die physikalischen Abläufe im Halbleiterkristall entsprechen weitgehend denen des Halbleiterkristalls nach Figur 2. Gleiche oder ähnliche Bestandteile des Halbleiterkristalls sind mit gleichen Bezugszeichen wie in Figur 2 versehen und werden nicht nochmals beschrieben. Im Gegensatz zu Figur 2 ist in Figur 5 der Leistungsschalttransistor 14 mit eingezeichnet, der sich mit seinem Schichtaufbau 220, 230 nach links hin fortsetzt. Die stark n-dotierte Schicht 220 bildet dabei über die darüberliegende Metallisierung den Emitter, der an Masse angeschlossen ist. Die stark n-dotierte Schicht 220 ist in die Basisschicht 230 eingebettet, die p-dotiert ist. Die Basisschicht ist über den Basisanschluß B ansteuerbar, wobei in der Basisschicht 230 eine stark n-dotierte Barriere 240 vorgesehen ist, die die Emitterschicht 220 in Richtung des Vierschichtelements abschirmt. Ferner ist in Figur 5 zusätzlich zur Figur 2 noch ein Kanalstopper 210 eingezeichnet, eine stark n-dotierte Schicht im Randbereich des Halbleiterkristalls zur Unterbindung von elektrischen Durchbrüchen im Randbereich des Halbleiterkristalls. Im Gegensatz zur Figur 2 weist das Ausführungsbeispiel nach Figur 5 keinen Brunnenwiderstand, mithin keine stark n-dotierte Schicht 41 bzw. kein entsprechendes "Loch" in der p-Dotierung der Schicht 30 auf. Das Vierschichtelement ist hier als autonomer Hilfskanal verschaltet; die stark n-dotierte Schicht 28 ist mit der Metallisierung 36b kontaktiert, die den Hilfskanalausgang 110 bildet, der mit Masse verbunden ist. Die Metallisierung 36c, die die p-dotierte Schicht 32 kontaktiert, bildet den Hilfskanaleingang 120. Der Steuereingang 130 des autonomen Hilfskanals 100 wird durch die Metallisierung 36a gebildet, die die p-dotierte Schicht 30 kontaktiert. Der aufbaubedingte Widerstand 170 wird durch den schwach n-dotierten Halbleiterbereich zwischen dem Bereich 34 und der Metallisierung 40 gebildet. Der aufbaubedingte Widerstand 170 ist im Ersatzschaltbild der Figur 1 zur Vereinfachung der Darstellung mittels eines Thyristorsymbols nicht eingezeichnet, obwohl dieser Widerstand in der Schaltungsanordnung nach Figur 2 genauso vorhanden ist. Die aufbaubedingte Diode 160 wird durch den PN-Übergang zwischen der Schicht 32 und dem Halbleiterbereich 24 gebildet. In Figur 1 ist keine aufbaubedingte Diode eingezeichnet, da in dem Schaltungsaufbau nach Figur 2 diese aufbaubedingte Diode durch einen Kurzschluß (Bonddraht) zwischen Anode und Kollektor kurzgeschlossen ist. Der Kondensator 190 und der Widerstand 200 sind in Figur 5 nicht eingezeichnet, sie sind durch externe Bauelemente realisierbar. In der Grundversion sind beide Bauelemente, d.h. das Bauelement nach Figur 2 und das nach Figur 5, mit 5 Klemmen ausgestattet: In Figur 2 sind es die Anschlüsse B, 40, 36a, 36b und Masse, in Figur 5 sind es die Anschlüsse B, 40, 130, 120 und Masse.

Den Bauelementen nach Figur 5 und Figur 2 ist ein laterales Vierschichtelement gemeinsam, das durch Diffusion von p-dotierten Zonen in einen schwach n-dotierten Halbleitergrundkörper und einer in eine der p-dotierten Zonen diffundierten stark n-dotierten Zone als Kathode gebildet wird. Gezündet wird über den Übergang zwischen der stark n-dotierten Zone und der diese stark n-dotierende Zone umgebenden p-dotierten Zone. In Figur 5 ist der p-dotierte Emitter jedoch im Gegensatz zur Figur 2 nicht mit dem Kollektor des vertikalen Leistungsschalttransistors verbunden, sondern er stellt den Eingang 120 eines autonomen Hilfkanals dar, der je nach Anwendung des Hilfskanals beschaltbar ist. Ist der durch den Hilfskanal gegebene Hilfsstrompfad nicht wie im vorliegenden Schaltungsbeispiel nach Figur 4 selbstlöschend, sondern soll der Stromfluß aktiv unterbrochen werden, so kann der Emitter des zweiten Teiltransistors 150 in einer Kaskodenschaltung über einen externen oder integrierten Niederspannungstransistor geführt werden. Im übrigen dient die Barriere 240 unterhalb des Basisanschlusses B des Leistungsschalttransistors 14 zur Unterdrückung einer hier unerwünschten lateralen Injektion von Elektronen aus der Emitterschicht 220 in das schwach n-dotierte Gebiet 24.

## Patentansprüche

1. Schaltungsanordnung, insbesondere zum Ansteuern einer Zündendstufe, mit einem Leistungsschalttransistor und mindestens einem schaltbaren elektrischen Hilfspfad, wobei der mindestens eine Hilfspfad als Freilaufkreis und/oder als Hilfskanal ausgebildet ist, wobei der elektrische Hilfspfad (42) von einem ansteuerbaren Vierschichtelement (16) gebildet wird, **dadurch gekennzeichnet, daß** neben dem lateralen Stromfluß im Vierschichtelement (28, 30, 32, 34) ein zusätzlicher vertikaler Stromfluß von der Rückseite (40) des Bauelements (22) zu einer Metallisierung (36 B) erfolgt und dadurch der stromführende Querschnitt vergrößert wird, wobei die Metallisierung (36 B) die Kathode (28) des Vierschichtelements kontaktiert, und daß die Anode (32) des Vierschichtelements (16) in Richtung zur Kathode (28) von einer auf Anodenpotential liegenden Feldplatte (36 C) so überlappt wird, daß eine von der Kathodenseite mögliche Sperrschichtberührung durch einen entsprechenden Überstand der Feldplatte (36C) vermieden wird.

2. Schaltungsanordnung nach Anspruch 1, **dadurch gekennzeichnet, daß** das Vierschichtelement (16) in den Leistungsschalttransistor (14) monolithisch integriert ist.

3. Schaltungsanordnung nach einem der vorhergehenden Ansprüche, **dadurch gekennzeichnet, daß** das Vierschichtelement (16) als laterales Bauelement in das den Leistungsschalttransistor (14) aufweisende Bauelement (22) integriert ist.

4. Schaltungsanordnung nach Anspruch 3, **dadurch gekennzeichnet, daß** das Vierschichtelement (16) als laterales Bauelement in einem Randbereich des den Leistungs schalttransistor (14) aufweisenden Bauelements (22) integriert ist.

5. Schaltungsanordnung nach einem der vorhergehenden Ansprüche, **dadurch gekennzeichnet, daß** das Vierschichtelement (28, 30, 32, 34) eine stark n-dotierte Zone (28), eine die stark n-dotierte Zone (28) umgreifende p-dotierte Zone (30), eine weitere p-dotierte Zone (32) und eine zwischen den p-dotierten Zonen (30, 32) liegende n-dotierte Zone (34) aufweist.

6. Schaltungsanordnung nach Anspruch 6, **dadurch gekennzeichnet, daß** die stark n-dotierte Zone (28) geschlitzt ist, so daß über p-dotierte Bereiche (43) der p-dotierten Zone (30) ein Zündstrom direkt in den Grenzbereich zwischen der p-dotierten Zone (30) und der n-dotierten Zone (34) eingespeist werden kann.

## Claims

1. Circuit arrangement, in particular for driving an ignition output stage, having a power switching transistor and at least one switchable electrical auxiliary path, the at least one auxiliary path being designed as a freewheeling circuit and/or as an auxiliary channel, the electrical auxiliary path (42) being formed by a drivable four-layer element (16), **characterized in that**, in addition to the lateral current flow in the four-layer element (28, 30, 32, 34), an additional vertical current flow is effected from the rear side (40) of the component (22) to a metallization layer (36 B), and the current-carrying cross section is enlarged as a result, the metallization layer (36 B) contact-connecting the cathode (28) of the four-layer element, and **in that** the anode (32) of the four-layer element (16) is overlapped, in the direction towards the cathode (28), by a field plate (36 C), which is at anode potential, in such a way that a punch-through possible from the cathode side is avoided by virtue of a corresponding overhang of the field plate (36 C).

2. Circuit arrangement according to Claim 1, **characterized in that** the four-layer element (16) is monolithically integrated into the power switching transistor (14).

3. Circuit arrangement according to one of the preceding claims, **characterized in that** the four-layer element (16) is integrated as a lateral component into the component (22) having the power switching transistor (14).

4. Circuit arrangement according to Claim 3, **characterized in that** the four-layer element (16) is integrated as a lateral component in an edge region of the component (22) having the power switching transistor (14).

5. Circuit arrangement according to one of the preceding claims, **characterized in that** the four-layer element (28, 30, 32, 34) has a heavily n-doped zone (28), a p-doped zone (30) enclosing the heavily n-doped zone (28), a further p-doped zone (32) and an n-doped zone (34) lying between the p-doped zones (30, 32).

6. Circuit arrangement according to Claim 6, **characterized in that** the heavily n-doped zone (28) is slotted, so that, via p-doped regions (43) of the p-doped zone (30), an ignition current can be fed directly into the boundary region between the p-doped zone (30) and the n-doped zone (34).

## Revendications

1. Circuit notamment pour commander un étage final d'allumage comprenant un transistor de commutation de puissance et au moins un chemin auxiliaire électrique commutable, ce chemin auxiliaire étant réalisé comme circuit de roue libre et/ou comme canal auxiliaire, et le chemin auxiliaire électrique (42) étant formé par un élément à quatre couches (16), commandé,
**caractérisé en ce que**
à côté du passage latéral du courant dans l'élément à quatre couches (28, 30, 32, 34) on a un passage de courant vertical supplémentaire de la face arrière (40) du composant (22) vers la métallisation (36B) et ainsi on augmente la section conduisant le courant, la métallisation (36B) mettant en contact la cathode (28) de l'élément à quatre couches, et l'anode (32) de l'élément à quatre couches (16) est chevauché en direction de la cathode (28) par une plaque de champ (36C) mise au potentiel de l'anode pour éviter un contact possible de la couche de blocage du côté de la cathode par un débordement adéquat de la plaque de champ (36C).

2. Circuit selon la revendication 1,
**caractérisé en ce que**
l'élément à quatre couches est intégré de manière monolithique dans le transistor de commutation de puissance (14).

3. Circuit selon l'une des revendications précédentes,
**caractérisé en ce que**
l'élément à quatre couches (16) est un composant latéral intégrant le composant (22) comportant le transistor de puissance (14).

4. Circuit selon la revendication 3,
**caractérisé en ce que**
l'élément à quatre couches (16) est un composant latéral intégré dans la zone du bord du composant (22) comportant le transistor de puissance (14).

5. Circuit selon l'une des revendications précédentes,
**caractérisé en ce que**
l'élément à quatre couches (28, 30, 32, 34) comporte une zone (28) à fort dopage n, une zone (30) à dopage p entourant la zone (28) à fort dopage n, une autre zone (32) à dopage p et une zone (34) à dopage n située entre les zones à dopage p (30, 32).

6. Circuit selon la revendication 5,
**caractérisé en ce que**
la zone (28) à fort dopage n est fendue de sorte qu'un courant d'allumage puisse être fourni directement à la zone limite entre la zone (30) à dopage p et la zone (34) à dopage n, par les zones (43) à dopage p de la zone (30) à dopage p.
